# EUROPEAN PATENT APPLICATION

(11) **EP 0 878 853 A1**
(43) Date of publication of application: **18.11.1998**
(21) Application number: 98303870.4
(22) Date of filing: 15.05.1998
(51) Int. Cl.: H01L 41/09

(54) **Ultrasonic motor and ultrasonic motor-equipped electronic appliance**

(30) Priority: 16.05.1997 JP 127596/97; 13.04.1998 JP 101570/98
(71) Applicant: SEIKO INSTRUMENTS INC., Chiba-shi, Chiba 261 (JP)
(72) Inventor: Kasuga, Masao, Mihama-ku, Chiba-shi, Chiba (JP); Iino, Akihiro, Mihama-ku, Chiba-shi, Chiba (JP); Suzuki, Makoto, Mihama-ku, Chiba-shi, Chiba (JP); Suzuki, Kenji, Mihama-ku, Chiba-shi, Chiba (JP)
(74) Representative: Sturt, Clifford Mark

(57) **Abstract**

An ultrasonic motor comprises a piezoelectric flexing vibration member 11 which makes its flexing vibration due to the application of a voltage and a piezoelectric stretching vibration member 12 which is integrally laminated on the piezoelectric flexing vibration member 11 and makes its stretching vibration due to the application of a voltage. A movable body 20 is moved by a synthetic vibration of the flexing vibration of the piezoelectric flexing vibration member 11 and the stretching vibration of the piezoelectric stretching vibration member 12. Also, the ultrasonic motor comprises a first electrode 14 which is provided at the portion of surfaces opposing the lamination surfaces of the piezoelectric flexing vibration member 11 in which the piezoelectric flexing vibration member 11 is to be polarisation processed. A second electrode 16 is provided at the portion of surfaces opposing lamination surfaces of the piezoelectric stretching vibration member 12 in which the piezoelectric stretching vibration member 12 is to be polarisation processed. A reference electrode 15 is provided at a lamination surface between the piezoelectric flexing vibration member 11 and the piezoelectric stretching vibration member 12 and serves as a reference for the first and the second electrodes 14 and 16.

## Description

The present invention relates to an ultrasonic motor. The ultrasonic motor comprises piezoelectric vibration members laminated one upon another. The present invention relates in particular to an improvement of the type of ultrasonic motor which uses no retaining means when the piezoelectric vibration members are laminated.

Recently in the field off a micromotor, attention has been drawn toward an ultrasonic motor wherein a moving body is moved using a piezoelectric vibrator that vibrates due to the application of a voltage.

Particularly, an ultrasonic motor which uses a stretching vibration and flexing vibration off a rectangular piezoelectric vibrator (dual-mode vibrator) is used tar various use purposes because this synthetic-vibration is used to cause straight-line movements, rotary movements, etc. of a moving body. Further, a type of piezoelectric vibrators which are laminated also is used for the purposes requiring a high output (see Japanese Patent Application Laid-open Publication No. Hei-7-184382).

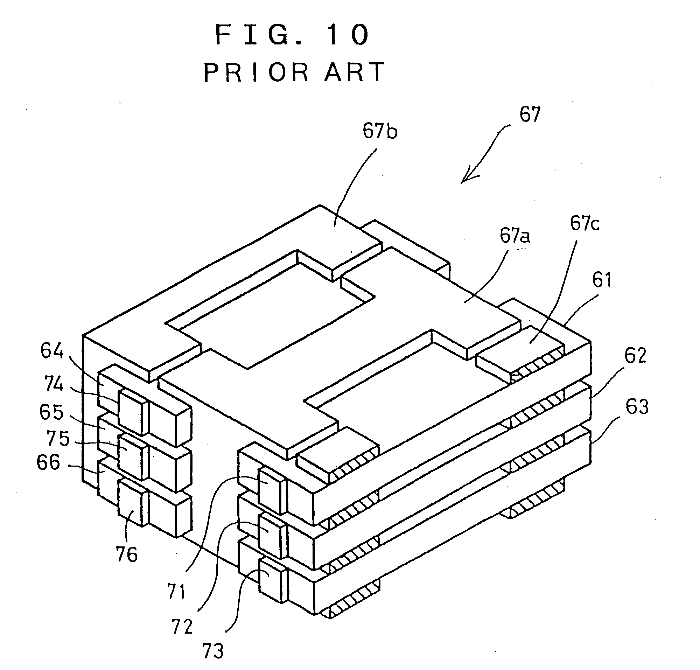

FIG. 10 illustrates a type of ultrasonic motor wherein rectangular piezoelectric vibrators are laminated.

Namely, a basic vibrator of the ultrasonic motor is comprised of piezoelectric oscillators 61 and 62 with respect to which a prescribed polarisation processing is performed for vibrating each of them in two modes. Output taking members 71 and 72 have been provided at forward ends of the piezoelectric oscillators 61 and 62. Electrodes have been provided on both surfaces off each of the piezoelectric oscillators 61 and 62. The piezoelectric oscillators 61 and 62 are stacked vertically in three stages and arranged laterally in two rows and these six piezoelectric vibrators are retained by connecting means 67a and 67b.

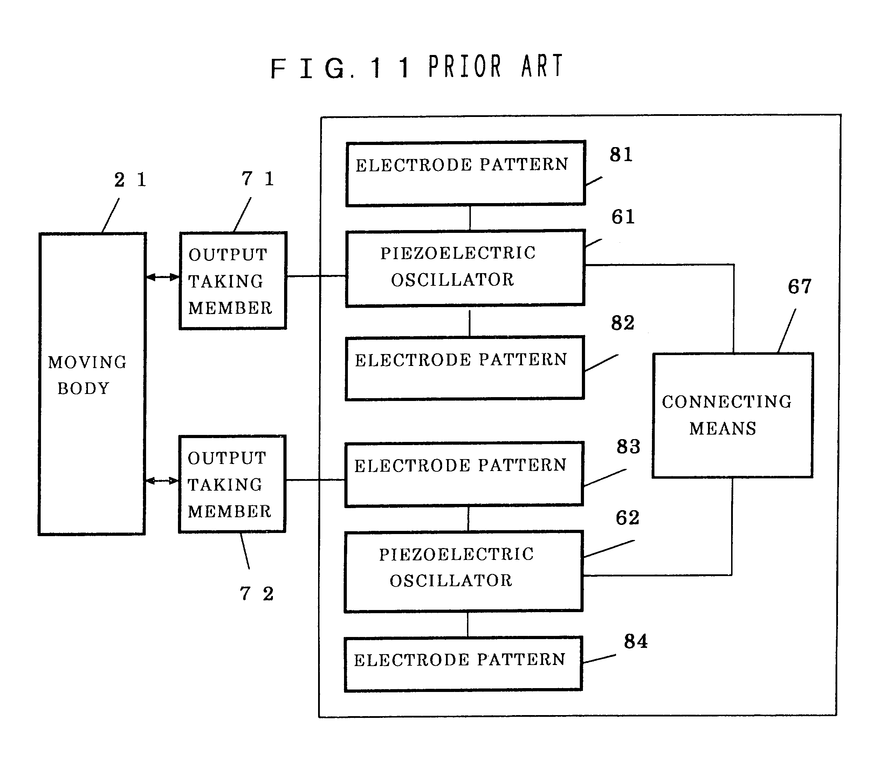

FIG. 11 is a block diagram illustrating a basic structure off the above-described ultrasonic motor.

According to this structure, the piezoelectric oscillators 61 and 62 are dual-mode vibrated by applying with a voltage from electrode patterns 81 and 82, respectively. This synthetic vibration is transmitted to each of the respective output taking members 71 and 72, and a moving body 21 is moved which is kept in abutment with the output taking members 71 and 72.

Since the output is taken out from a plurality of the output taking members 71 and 72, a high output is obtained.

However, according to the above-described ultrasonic motor, since respective parts of the piezoelectric oscillators 61 and 62 are only fixed by the connecting means 67, there exists the technical problem that the vibration directional dispersion occurs between the respective piezoelectric oscillators 61 and 62 and also, since the vibration movements are suppressed at :he respective fixed portions of the piezoelectric oscillators 61 and 62, a loss of the vibration movement occurs with the result that the output cannot be taken out most effectively.

Also, the connecting means 67, which is a separate member, is used for fixing the piezoelectric oscillators 61 and 62, it unpreferably results in the construction of the entire motor becoming large in size and complex. In addition, since the step of mounting the connecting means 67 is added, the manufacturing process becomes more complex.

Meanwhile, in the respective piezoelectric oscillators 61 and 62, each of which makes its dual-mode vibrations, a voltage is applied to prescribed polarisation processed portions thereof for the purpose of changing over the movement direction of the motor through the flexing vibrations. Therefore, there exists the technical problem that the stretching vibrations which are incidentally caused cannot be enlarged compared no the flexing vibrations which are generated.

It is an object of the present invention to provide an ultrasonic motor which prevents the dispersion in the vibration direction and the vibration loss of the laminated piezoelectric vibrator and desirably miniaturises and simplifies the laminated structure, and increases the output of the synthetic vibration, as well as an ultrasonic motor-equipped electronic appliance.

Namely, the invention as described in claim 1 comprises a piezoelectric flexing vibration member that makes its flexing vibration due to the application of a voltage, and a piezoelectric stretching vibration member that is integrally laminated an the piezoelectric flexing vibration member and makes its stretching vibration due to the application of a voltage.

Thus, the present invention enables a movable body to be moved by a synthetic vibration or the flexing vibration of the piezoelectric flexing vibration member and the stretching vibration of the piezoelectric stretching vibration member.

As the function of the above-described invention, since it has been arranged that the vibration movement is not limited and the vibration direction is kept fixed by retaining the piezoelectric flexing vibration member and piezoelectric stretching vibration member but using no fixing means, any loss of vibration movement and dispersion in the vibration direction of each piezoelectric vibration member is prevented.

Also since the stretching movement can be generated by providing the piezoelectric stretching vibration member, it is possible to make the stretching vibration large, and the output of the synthetic vibration of this stretching vibration and the flexing vibration becomes high compared to that which is obtained from a laminate of the respective piezoelectric vibration members each making its dual-mode vibration.

Also, from the viewpoint of using a common reference, this decreases the number of electrodes and simplifies the apparatus construction.

As the function of the above-described invention the piezoelectric flexing vibration member is flexure vibrated by the application of a voltage between the first electrode and the reference electrode and the piezoelectric stretching vibration member is vibrated to stretch by the application of a voltage between the second electrode and the reference electrode, whereby a movable body is moved by the resulting synthetic vibration.

Since the respective electrodes are excited by supplying electric current to only the electrode surface of the electrode wiring member, there is no need to individually wire the respective electrodes. Besides the piezoelectric vibration member and the piezoelectric stretching vibration member can be polarisation processed at the same time.

Thus in accordance with the present invention a movable body is moved by the large synthetic vibration resulting front the flexing vibration based on the use of the two piezoelectric flexing vibration members.

In the present invention the displacement of the synthetic vibration of the piezoelectric flexing vibration member and the piezoelectric stretching vibration member is enlarged by the vibration transmission member.

In addition, the present invention relates to an ultrasonic motor-equipped electronic appliance, which is equipped with the ultrasonic motor herein.

Embodiments of the present invention will now be described with reference to the accompanying drawings, of which:
FIG. 1A is an explanatory view showing a planar structure of a first embodiment wherein the present invention has been applied to an ultrasonic motor, and FIG. 1B is an explanatory view showing a sectional structure thereof;
FIG. 2A,2B,2C,2D and 2E are explanatory views showing planar structures of the respective laminated layers of FIGs. 1A and 1B and side surfaces of the vibrator portions thereof;
FIG. 3 is a block diagram associated with FIGS 1A and 1B;
FIG. 4 is an explanatory view showing modes of vibration associated with FIGs. 1A and 1B;
FIG. 5A is an explanatory view showing a planar structure of a second embodiment wherein the present invention has been applied to an ultrasonic motor, and FIG. 5B is an explanatory view showing a sectional structure thereof;
FIG. 6A,6B,6C,6D,6E,6F,6G and 6H are explanatory views showing planar structures of the respective laminated layers of FIG. 5A and 5B and side surfaces of the vibrator portions thereof;
FIG. 7 is a block diagram showing a main part when the movable body associated with FIG. 5A and 5B is moved to the left;
FIG. 8 is an explanatory view showing modes of vibration associated with FIG. 5A and 5B;
FIG. 9 is an explanatory view showing a third embodiment wherein the present invention has been applied to an electronic appliance;
FIG. 10 is an explanatory view showing the structure of an ultrasonic motor having a laminated structure associated with a conventional technique, as viewed from an oblique direction; and
FIG. 11 is a block diagram showing a basic structure associated with FIG. 10.

### (First Embodiment)

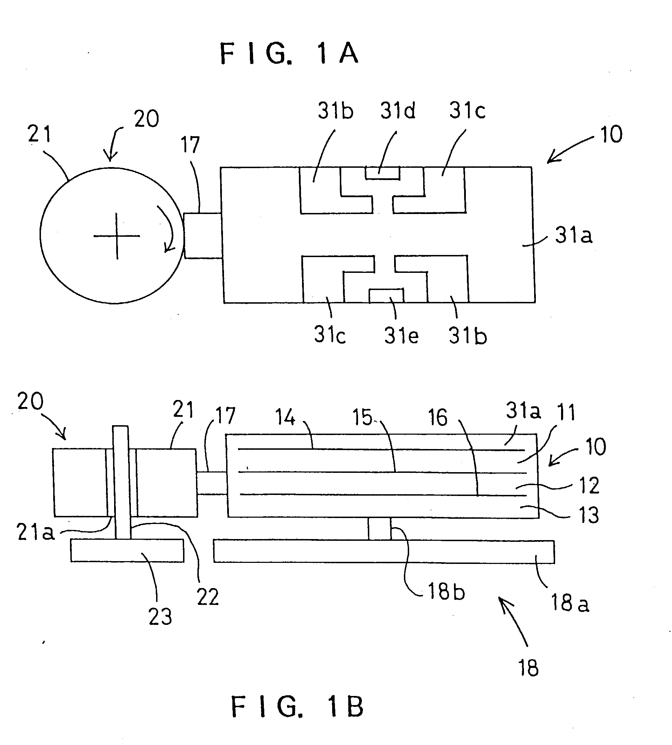

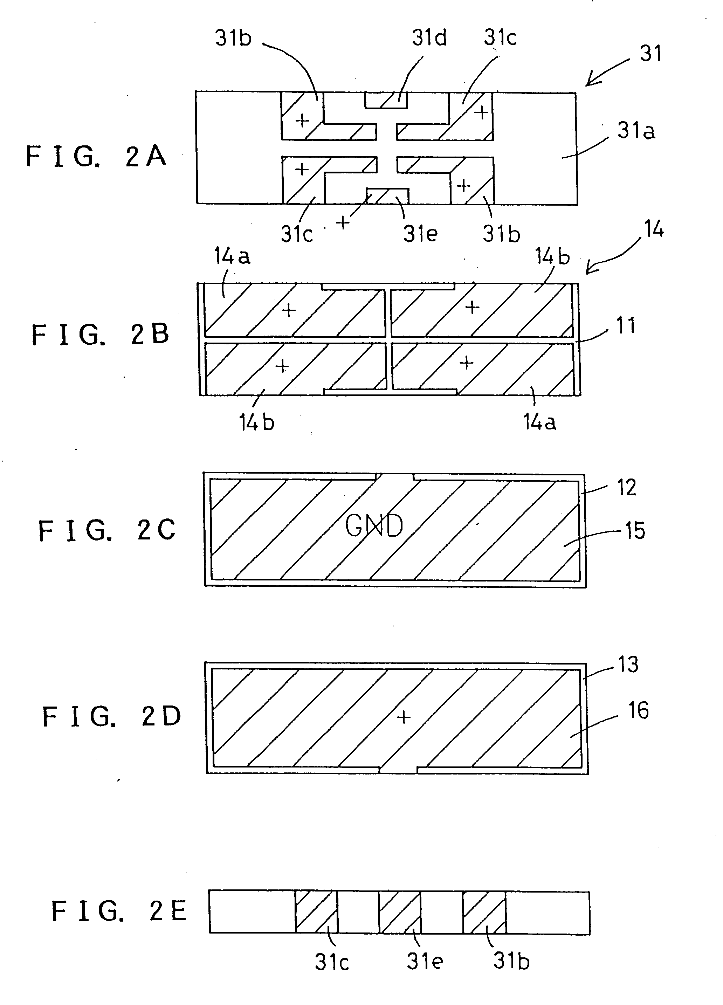

FIGs. 1A and 13 illustrate a first embodiment wherein the present invention has been applied to an ultrasonic motor.

As illustrated in FIGs. 1A and 1B, this embodiment comprises a vibrator 10, an output taking member 17 provided on an edge portion of the vibrator 10 and serving as a vibration transmission member of the present invention. A moving body 20 is abutted on the output taking member 17 and serves as a movable body of the present invention. A pressing mechanism 18 is provided for applying pressure to the moving body 20 and the output taking member 17.

The moving body 20 comprises a rotating member 21 having a rotating shaft bearing 21a, a fixed member 23 provided in opposed relationship to the rotating member 21, and a rotating shaft 22 installed on the fixed member 23 and passing through the rotating shaft bearing 21a of the rotating member 21.

The output taking member 17 is shaped like a rectangular parallelopiped and is made of material having a rigidity.

The pressing mechanism 18 comprises a fixed member lea provided opposing the vibrator 10, and a pressurising member 18b for pressurising the vibrator 10 with respect to the moving body 20.

FIGs. 2A to 25 illustrates planes of respective laminated layers of the vibrator portion and the side surface of the vibrator portion.

As illustrated in FIGs. 2A to 2D, the vibrator portion 10 comprises a piezoelectric member 11 which makes its flexing vibration due to the application of a voltage and serves as a piezoelectric flexing vibration member of the present invention. A piezoelectric member 12 is integrally laminated on the piezoelectric member 11 and makes its stretching vibration and so serves as a piezoelectric stretching vibration member of the present invention. A piezoelectric member 13 is further integrally laminated on the piezoelectric member 12. An electrode pattern 16 is provided between the piezoelectric member 13 and the piezoelectric member 12. An electrode pattern 15 provided between the piezoelectric member 12 and the piezoelectric member 11. An electrode pattern 14 is provided at a surface opposing the lamination surface of the piezoelectric member 11 over the piezoelectric member 12. An electrode wiring member 31 is integrally laminated on the electrode pattern 14 surface of the piezoelectric member 11 and serves as the electrode wiring member of the present invention.

Here, as illustrated in FIGs. 2B and 2C, the piezoelectric members 11 and 12 are each shaped into a rectangular plane and are each fabricated into a dimension for setting a prescribed resonance frequency and are each made of ferroelectric material such as barium titanate and lead titanate zirconate.

The rectangular piezoelectric member 11 is further divided into four smaller equal parts in the crosswise directions, whereby a pair of the rectangular members arranged in the diagonal direction are polarisation processed to the same polarity and a pair of the rectangular members in the side direction are also polarisation processed to the same polarity.

On the other hand, the rectangular piezoelectric member 12 is almost wholly polarisation processed to the same polarity.

As illustrated in FIG. 2B, the electrode patterns 14a and 14b are arranged by being divided into four parts in correspondence with the polarisation processed portions of the piezoelectric member 11. A pair of the electrodes 14a and a pair of the electrodes 14b as viewed in the diagonal direction are applied with a respective voltage at the same time.

Also, each of the respective electrode patterns 14a and 14b has provided thereon a protruding portion in such a way that this protruding portion reaches a long edge portion, nearer thereto, of the rectangular surface of the piezoelectric member 11.

As illustrated in FIG. 2C, the electrode pattern 15 is provided on almost the entire region of the rectangular surface of the piezoelectric member 12 and has provided thereon a protruding portion in such a way that this protruding portion reaches the centre of one of the pair of long sides of the rectangular surface of the piezoelectric member 12.

As illustrated in FIG. 2D, the electrode pattern 16 is arranged on almost the entire surface of the piezoelectric member 13 and has provided thereon a protruding portion in such a way that this protruding portion reaches the centre of the long edge portion, on a side opposite to that in the case of the electrode pattern 15, of a pair of long sides of the rectangular surface of the piezoelectric member 12.

As illustrated in FIGs. 2A and 2E, the electrode wiring member 31 comprises a piezoelectric member 31a, and electrode patterns 31b, 31c, 31d and 31e to the portions corresponding to the protruding portions of the respective electrode patterns 14, 15 and 16.

The electrode pattern 31b for applying voltage reaches the long edge portions, or thereto, of the rectangular surface and, as illustrated in FIG. 2E, extend up to the side surfaces of the vibrator 10 and thereby connect to the respective electrode patterns 14.

Next, the method of use of this embodiment will be explained with reference to FIGs. 1 to 4.

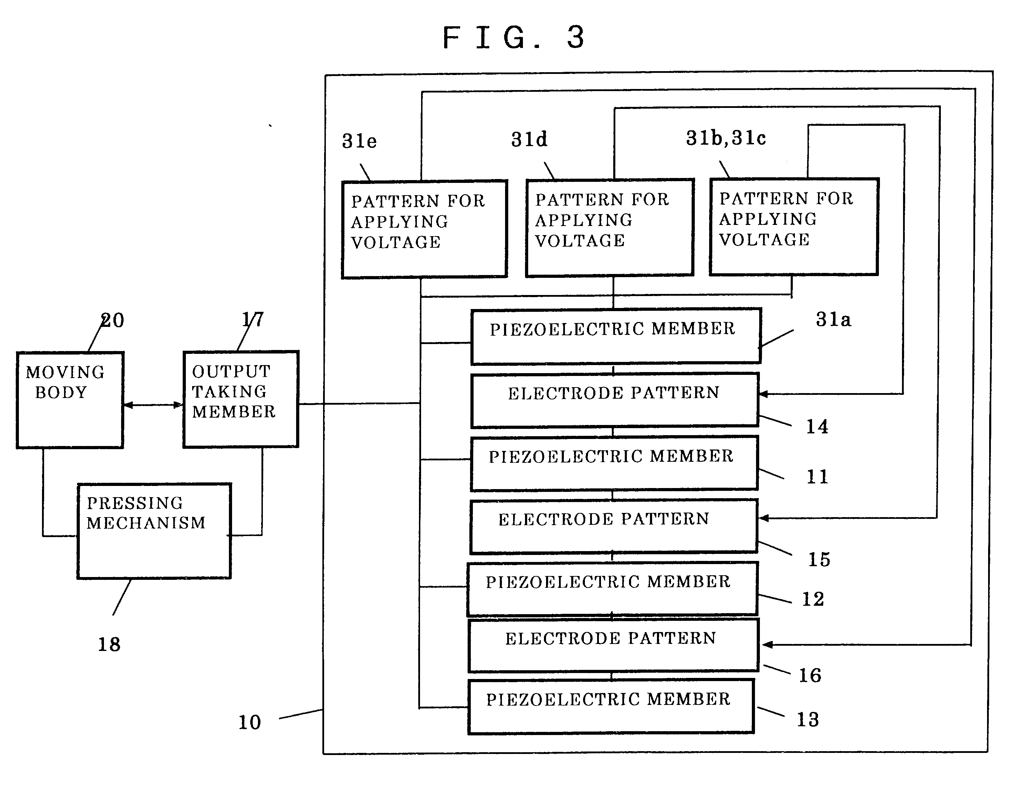

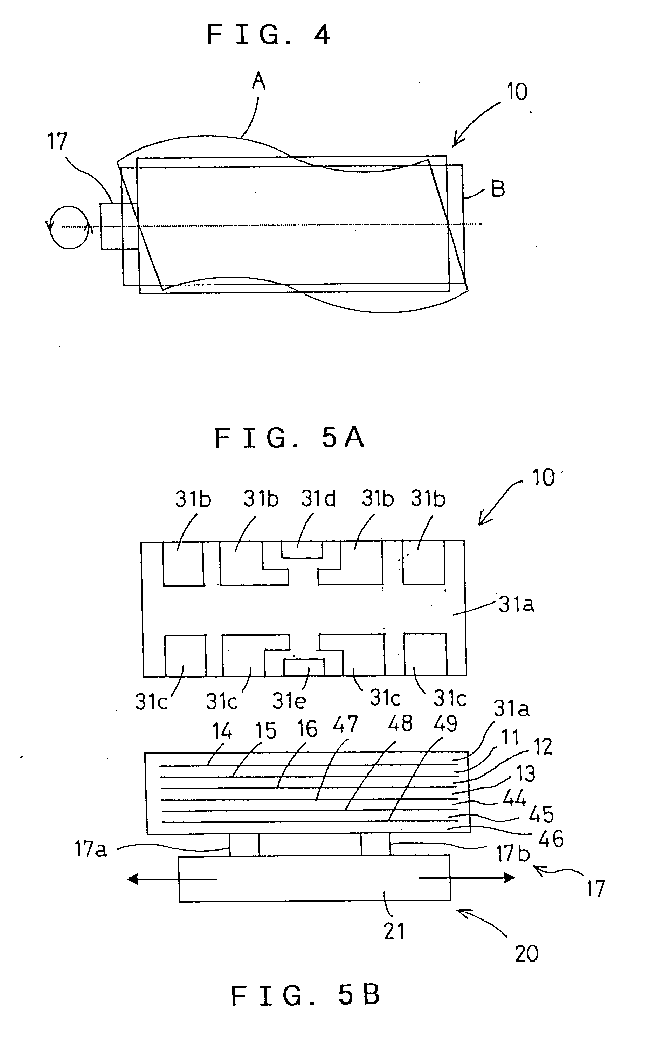

FIG. 3 is a block diagram illustrating an ultrasonic motor according to this embodiment and FIG. 4 illustrates the modes of vibration of the piezoelectric member according to this embodiment.

First, when wanting to rotate clockwise the rotating member 21 which is part of the moving body 20, it is sufficient to apply a voltage to the electrode patterns for applying voltage 31b, 31d and 31e as illustrated in FIG. 3.

As a consequence, the electrode patterns 14a, 15 and 16 are excited. Here, the piezoelectric member 11 between the electrode patterns 14a and 15 is caused to make its flexing vibration in the lateral direction such as that indicate by (A) of FIG. 4 while, on the other hand, the piezoelectric member 12 between the electrode patterns 15 and 16 is caused to make its stretching vibrations in the vertical and lateral directions as indicated by (B) of FIG. 4.

In this case, the vibration direction of each piezoelectric member 11 is kept fixed and no limitation is imposed on the vibration movement. Also, since the piezoelectric member 12 is applied with a voltage over almost the entire surface thereof, the piezoelectric member 12 is stretch vibrated to a large extent.

Since the respective piezoelectric members 11 and 12 are integral with each other, the flexing vibration and stretching vibration of the respective piezoelectric members 11 and 12 are synthesised with the result that the short edge portions of the rectangular surface each make their elliptic movements in the counter clockwise direction.

The output taking member 17 fixed to the short edge portion of the rectangular surface enlarges the elliptic movement and pressure contacts the rotating member 21 of the moving body 20 with a prescribed timing.

Accordingly, the rotating member 21, which is part of the moving body 20 and pressure contacted with the prescribed timing, receives the frictional force each time it is abutted on, whereby the rotating member 21 is rotated clockwise.

When wanting to rotate the rotating member 21 counter clockwise, it is sufficient to apply a voltage to the electrode patterns 31c, 31d and 31e for applying voltage as illustrated in FIG. 3.

At this time, the electrode patterns 14b, 15 and 16 are excited. Here, the piezoelectric member 11 between the electrode patterns 14b and 15 is caused to make its flexing vibration opposite in phase to that indicated by (A) of FIG. 4 while, on the other hand, the piezoelectric member 12 between the electrode patterns 15 and 16 is caused to make its stretching movement such as that indicated by (B) of FIG. 4.

Since the respective piezoelectric members 11 ant 12 are made integral with each other, the flexing vibration and stretching vibration of the respective piezoelectric members it and 12 are synthesised with the result that the short edge portions of the rectangular surface each make their elliptic movements in the clockwise direction.

Accordingly, the rotating member 21 which is abutted with the prescribed timing receives the frictional force each time it is abutted on the output taking member 17, whereby the rotating member 21 is rotated counter clockwise,

As described above, according to this embodiment, since it has been arranged that no limitation is imposed on the vibration movement and the vibration direction is kept fixed by retaining the piezoelectric member 11 with using no fixing means, there is no vibration movement loss and the vibration-directional dispersion of each piezoelectric member 11 is prevented.

Also, since the stretching movement is forced on the piezoelectric member, it is possible to make the stretching vibration large. Thus, the output of the synthetic vibration of this stretching vibration and the flexing vibration becomes high when compared to that which is obtained from a laminate of the respective piezoelectric members each making its dual-mode vibration.

Since a voltage is applied between the electrode patterns 14 and 15 and between the electrode patterns 5 and 16, the electrode pattern 15 is commonly used as a reference. This leads to a simplification of the apparatus construction.

In addition, since it has been arranged for the respective electrode patterns to be excited by supplying electric current only to the electrode surface 31b of the electrode wiring member 31, there is no need to individually wire the respective electrode patterns 14. Moreover, the piezoelectric members 11 and 12 can be polarisation processed at the same time.

Also, since the displacement of the synthetic vibration Of the piezoelectric members 11 and 12 is enlarged by the output taking member 17, the rotating member 21, pressure contacted by a forward end of the output taking member 17, is rotated by receiving a greater frictional force.

Finally, since the output taking member 17 is brought into pressure contact with the rotating member 21 with the prescribed timing for applying frictional force thereto as a consequence of the synthetic vibration of the piezoelectric members 11 and 12, the rotating member 21 is rotated.

### (Second Embodiment)

FIG. 5A and 5B illustrate a second embodiment wherein the present invention is applied to an ultrasonic motor.

A main part of this embodiment comprises, as illustrated in FIG. 5A and 5B, a vibrator portion 10, an output taking member 17 which is provided on an edge portion of the vibrator portion 10 and serves as a vibration transmission member. A moving body 20 is abutted to the output taking member 17 and serves as a movable body. A pressurising mechanism (not illustrated) is provided for pressurising the moving body 20 and the output taking member 17.

The moving body 20 has a straight-line movement member 21 which has a guide groove (not illustrated) and linearly moves in a prescribed direction and a regulation member (not illustrated) which regulates the movement direction of the straight-line movement member 21 by being paired with the guide groove.

The output taking member 17 has a construction similar to that of the first embodiment and is provided on the underside of the vibrator portion 10. The output taking member comprises a pair in number and are arranged at positions which are equi-distant from the centre portion in the right and left directions.

The pressurising mechanism has a structure which pressurises the vibration mode portions of the upper surface of the vibrator portion 10 in the downward direction.

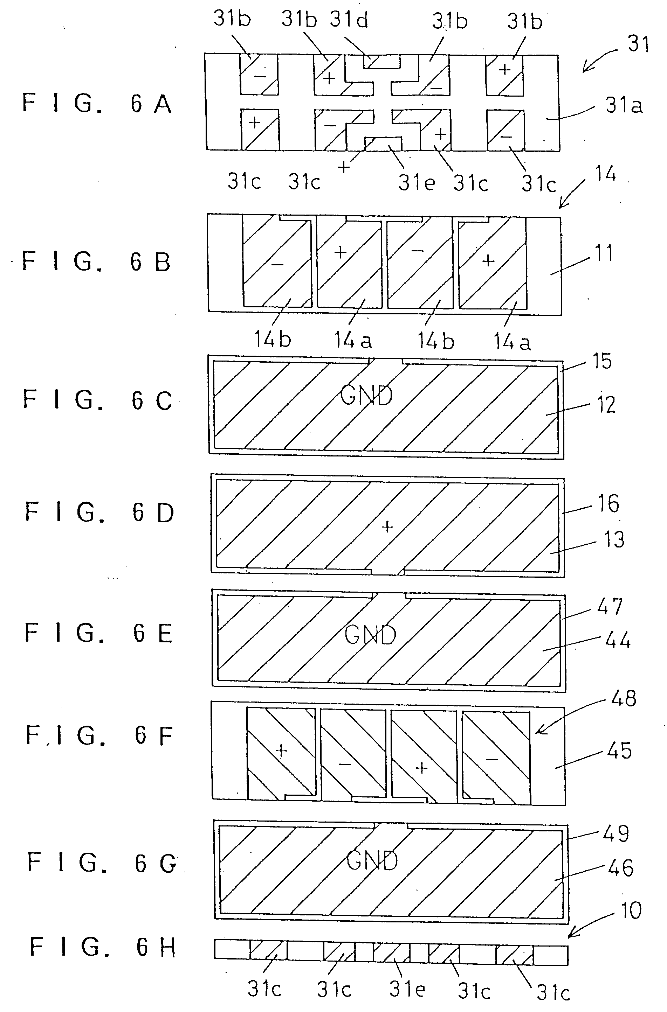

FIGs. 6A to 6H illustrate the planes of the respective laminated layers of the vibrator portion and the side surface thereof.

As illustrated in FIGs. 6A to 6G, the vibrator portion 10 comprises a piezoelectric member 11 which makes its flexing vibration due to the application of a voltage and serving as a piezoelectric flexing vibration member of the present invention. A piezoelectric member 12 which is integrally laminated on the piezoelectric member 11 and makes stretching vibration to serve as a piezoelectric stretching vibration member of the present invention. A piezoelectric member 13 is further integrally laminated on the piezoelectric member 12 and serves as a piezoelectric stretching vibration member of the present invention. A piezoelectric member 44 is integrally laminated on the piezoelectric member 13 and serves as a piezoelectric flexing vibration member of the present invention. A piezoelectric member 45 is integrally laminated on the piezoelectric member 44 and serves as a piezoelectric flexing vibration member of the present invention. Finally, a piezoelectric member 46 that is laminated on the piezoelectric member 45.

The vibrator portion 10 has between the respective piezoelectric members 11 electrode patterns 14 and 48 serving as first electrodes of the present invention and electrode pattern 16 serving as second electrodes of the present invention and electrode patterns 15, 47 and 49 serving as reference electrodes of the present invention. An electrode wiring member 31 is laminated on the electrode pattern 14 side of the piezoelectric member 11 and that serves as the electrode wiring member of the present invention.

As illustrated in FIG 6B, the piezoelectric member 11 has a structure similar to that in the case of the first embodiment and has a characterising feature in that the rectangular body thereof is divided into four smaller equal rectangular bodies. These rectangular bodies are polarisation processed so as to be alternately opposite in polarity to one another. On one rectangular surface there are provided electrode patterns 14a and 14b in correspondence with the positions at which polarisation processing is performed.

Also, every one of the respective electrode patterns 14a and 14b has a protruding portion that reaches one long edge portion.

On the other hand, as illustrated in FIG. 6D, the piezoelectric member 13 is similarly polarisation processed vertically in a reverse manner to the piezoelectric member 12.

Also, as illustrated in FIGs. 6E and 6F, the piezoelectric members 44 and 45 are polarisation processed so that the respective portions thereof are opposite in polarity to the corresponding polarisation processed portions of the piezoelectric member 11.

Although the electrode pattern 48 which is provided between the piezoelectric members 44 and 45 has substantially the same construction as that of the electrode pattern 14, the piezoelectric member 45 has provided thereon protruding portions on a side opposite to that on which the electrode pattern 14a has its protruding portion.

As illustrated in FIG. 6A, the electrode wiring member 31 comprises a piezoelectric member 31a serving as a main part. A pattern of electrodes 31b is provided for applying voltage and arranged at the positions corresponding to the protruding portions of the electrode patterns 14a and 14b. The electrode pattern 31c for applying voltage is provided at the positions corresponding to the protruding portions of electrode patterns 48a and 48b. An electrode pattern 31d is provided at the position corresponding to the protruding portion of the electrode patterns 15, 47 and 49. Finally, an electrode pattern 31e for applying is provided at the position corresponding to the protruding portion of the electrode pattern 16.

The respective electrode pattern 31b reaches the long edge portion, or nearer thereto of the rectangular surface of the piezoelectric member 31a and further extends up the side surface of the vibrator portion 10 and is thereby connected to the electrode pattern 14.

Next, the method of use of this embodiment will be explained with reference to FIGs. 5 to 8.

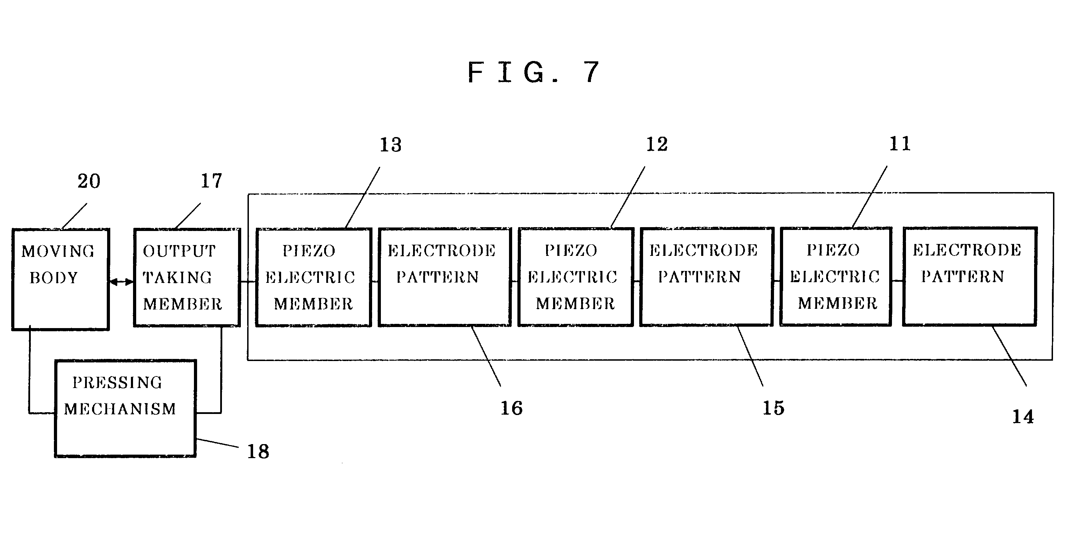

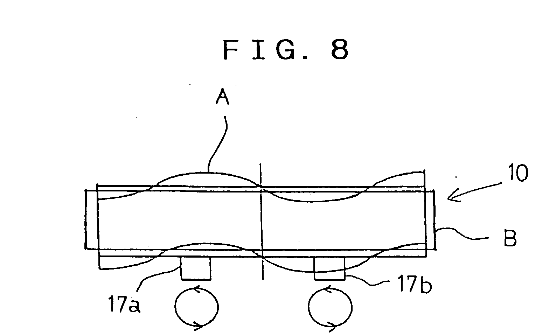

FIG. 7 is a block diagram illustrating a main part when moving the moving body 20 of this embodiment to the left and FIG. 8 illustrates the operation of the vibrator body portion according to this embodiment.

First, when wanting to linearly move the straight-line movement member 21 of the moving body 20 to the right, it is sufficient to apply a voltage to the electrode patterns 31c, 31d and 31e as illustrated in FIG. 6A.

At this time, the electrode patterns 15, 15, 48 and 49 are excited, and the piezoelectric members 44 and 45 between the electrode patterns 47, 48 and 49 are caused to make their flexing vibration in the vertical direction as indicated by (A) while, on the other hand, the piezoelectric members 12 and 13 between the electrode patterns 15, 16 and 47 are caused to make their stretching vibrations in the vertical and lateral directions as indicated by (B) of FIG. 8.

Since the respective piezoelectric members 44, 45, 12 and 13 are made integral with each other, the flexing vibration and stretching vibration of the respective piezoelectric members 44, 45, 12 and 13 are synthesised with the result that the respective portions on the underside of the vibrator body 10 each make their elliptic movements in the counter clockwise direction.

The pair of output taking members 17a and 17b fixed to the underside' of the vibrator portion 10 enlarges the elliptic movement and pressure contacts the straight-line movement member 21 of the moving body 20 with a prescribed timing.

Accordingly, the straight-line movement member 21, which is the moving body 20 pressure contacted with the prescribed timing, receives the frictional force each time it is abutted on, whereby the member 21 is linearly moved to the right.

When wanting to move the straight-line movement member 21 as the moving body 20 to the left, it is sufficient to apply a voltage to the electrode patterns for applying voltage 31b, 31d, and 31e as illustrated in FIG. 6A.

In this case, as illustrated in FIG. 6 and 7, the electrode patterns 14, 15, 16 and 47 are excited, and the piezoelectric members 11, 12 and 13 between the electrode patterns 14 are applied with a voltage.

Here, the piezoelectric member 11 makes its flexing movement whose phase is different by 180° from that of the movement indicated by (A) of FIG. 8 while, on the other hand, the piezoelectric members 12 and 13 between the electrode patterns 15 and 16 are caused to. make their stretching vibrations in the vertical and lateral directions as indicated by (B) of FIG. 8.

Since the piezoelectric members 11, 12 and 13 are made integral with each other, the flexing vibration and stretching vibration of the respective piezoelectric members 11, 12 and 13 are synthesised with the result that the respective portions on the underside of the vibrator body 10 each make their elliptic movements in the clockwise direction.

Accordingly, the straight-line movement member 21, which is the moving body 20 pressure contacted with the prescribed timing, receives the frictional force each time it is abutted on, whereby the member 21 is linearly moved to the left.

As described above, particularly, according to this embodiment, since the piezoelectric members 13 and 45 are further laminated, a large synthetic vibration is obtained with the result that the straight-line 21 is linearly moved with a higher output.

Also, since the output taking member 17 is brought into pressure contact with the straight-line movement member 21 with the prescribed timing to thereby apply the frictional force thereto by the synthetic vibration, the straight-line movement member 21 is linearly moved.

Incidentally, it may be also arranged that the vibrator portion 10 is pressurised and installed on a stationary surface so as to cause the ultrasonic motor itself to make its linear movement. At this time, the vibrator portion 10 causes the output taking members 17a and 17b to make their elliptic movements due to the synthetic vibration thereof, whereby the output taking members 17a and 17b receive the frictional force for each abutment onto the stationary surface and the ultrasonic motor itself linearly moves on the stationary surface.

### (Third Embodiment)

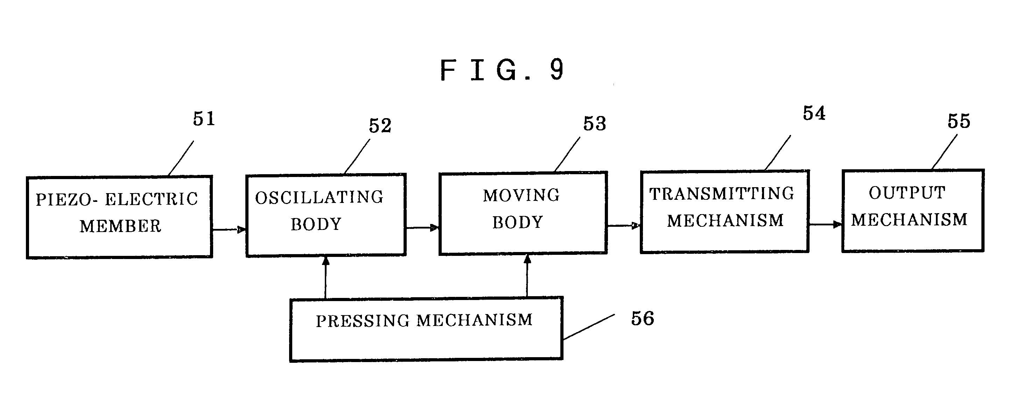

FIG. 9 is a block diagram illustrating an embodiment wherein the ultrasonic motor according to the present invention has been applied to an electronic appliance whose drive source is this ultrasonic motor.

This embodiment comprises a laminated type piezoelectric member 51, an oscillating body 52 which is vibrated by the laminated type piezoelectric member 51, a moving body 53 periodically pressure contacted by the vibrator oscillating body 52, a transmitting mechanism 54 which operates with the moving body 53, an output mechanism 55 which can be moved according to the operation of the transmitting mechanism 54, and a pressing mechanism 56 for pressurising the, oscillating body 52 and moving body 53.

In this case, as the transmitting mechanism 54 may comprise a transmission wheel such as a gear train, frictional wheel or the like.

The output mechanism 55 may comprise a shutter driving mechanism, lens driving mechanism or the like in the field of cameras, an indication hand or the like in the field of electronic timepieces or gauges, an arm in the field of robots, and a blade tool feeding mechanism, machining member feeding mechanism or the like in the field-of machine tools.

It is to be noted that, preferably, an electronic timepiece, gauge, camera, printer, printing machine, machine tool, robot, moving device or the like can be realised as an electronic appliance according to this embodiment.

Further, given the construction in which an output shaft is mounted on the moving body 53 and which has a power transmission mechanism for transmitting the torque from the output shaft, it is possible to realise an ultrasonic motor driven apparatus.

As described above, according to the invention, since it has been arranged that the vibration movement is not limited and the vibration direction is 'kept fixed by retaining the piezoelectric flexing vibration member and piezoelectric stretching vibration member but using no fixing means, any loss of vibration movement and dispersion in the vibration direction of each piezoelectric vibration member is prevented.

Also, since the stretching movement can be generated by providing the piezoelectric stretching vibration member, it is possible to make the stretching vibration large. Thus, the output of the synthetic vibration of this stretching vibration and the flexing vibration becomes high compared to that which is obtained from a laminate of the respective piezoelectric vibration members each making its dual-mode vibration.

Also, according to the present invention, since a voltage is applied between the reference electrode and a first electrode and between the reference electrode and the second electrode, the reference electrode is commonly used as a reference and the apparatus construction is simplified.

The present invention enables the respective electrodes to be excited by supplying electric current to only the electrode surface of the electrode wiring member. Thus, there is no need to individually wire the respective electrodes. Besides the piezoelectric flexing vibration member and the piezoelectric stretching vibration member can be polarisation processed at the same time.

Since it has been arranged that a larger synthetic vibration is obtained by enlarging the flexing vibration, the movable body is moved with a higher The same advantage occurs for enlarging the stretching vibration.

Similarly, an even larger output can be achieved since larger synthetic vibration is obtained by a plurality of piezoelectric flexing vibration members and a plurality of piezoelectric stretching vibration members.

As a consequence, the synthetic vibration of the piezoelectric flexing vibration member and the piezoelectric stretching vibration member is enlarged by the vibration transmission member, and so the movable body which is pressure contacted by the vibration transmission member receives a greater frictional force and is thereby moved.

With arranging the piezoelectric flexing vibration member and the piezoelectric stretching vibration member by pressure contact with the synthetic vibration, the movable body with the prescribed timing apply a frictional force to it, and so the movable body is linearly moved.

Similarly, with arranging the pressure contact between the movable body and a frictional force is applied thereto with the prescribed timing by the synthetic vibration, the movable body is rotated.

Finally, one could arrange that pressure contact is made to a stationary surface and a frictional force is applied therefrom with a prescribed timing by the synthetic vibration, so that the ultrasonic motor itself is moved on the stationary surface.

Lastly, the electronic appliance may be driven by the output of the ultrasonic motor in the form of a synthetic vibration.

The aforegoing description has been given by way of example only and it will be appreciated by a person skilled in the art that modifications can be made without departing from the scope of the present invention.

## Claims

1. An ultrasonic motor comprising:
a first piezoelectric vibration member (11); and
a second piezoelectric vibration member (12); characterised in that
said first and second members are laminated to each other, said first vibration member (11) effecting flexing vibration upon application of a voltage and said second vibration member (12) effecting stretching vibration upon application of a voltage.

2. An ultrasonic motor as claimed in claim 1, comprising:
a first electrode (14) being provided at a portion of the surface opposing the lamination surfaces of the first piezoelectric flexing vibration member;
a second electrode (16) being provided at a portion of the surface opposing the lamination surfaces of the second piezoelectric stretching vibration member; and
a reference electrode (15) being provided at a lamination surface between the first piezoelectric flexing vibration member and the second piezoelectric stretching vibration member and serving as a reference for the first and the second electrode.

3. An ultrasonic motor as claimed in claim 2, comprising:
an electrode pattern (31) for applying voltage having an electrode surface for exciting the respective electrodes and being further laminated on either the first piezoelectric flexing vibration member or the second piezoelectric vibration member.

4. An ultrasonic motor as claimed in claim 1, 2 or 3 comprising:
a third piezoelectric vibration member being further laminated on the first piezoelectric flexing vibration member (11).

5. An ultrasonic motor as claimed in any one of claims 1 to 4, comprising:
a fourth piezoelectric vibration member (13) being further integrally laminated on the second piezoelectric stretching vibration member.

6. An ultrasonic motor as claimed in claim 4 or 5, comprising:
a pair of further piezoelectric vibration members (44, 45) being further laminated on either the first piezoelectric flexing vibration member or the second piezoelectric stretching vibration member.

7. An ultrasonic motor as claimed in any one of the preceding claims comprising:
a vibration transmission member (17) for transmitting the synthetic vibration of two or more of the vibration members.

8. An ultrasonic motor as claimed in any one of the preceding claims, comprising:
a movable body (20) which is movable in a straight line direction being linearly moved by the synthetic vibration of the first piezoelectric flexing vibration member and the piezoelectric stretching vibration member.

9. An ultrasonic motor as claimed in any one of the preceding claims comprising:
a movable body (20) which is freely rotatable being rotated by the synthetic vibration of the first piezoelectric flexing vibration member and the second piezoelectric stretching vibration member.

10. An ultrasonic motor-equipped electronic appliance, characterised by being equipped with the ultrasonic motor as claimed in any one of claims 1 or 9.
